(19) **Europäisches Patentamt**
**European Patent Office**
**Office européen des brevets**

(11) **EP 4 684 883 A1**

(12) **EUROPEAN PATENT APPLICATION**
published in accordance with Art. 153(4) EPC

(43) Date of publication:
**28.01.2026 Bulletin 2026/05**

(21) Application number: **24810198.2**

(22) Date of filing: **06.05.2024**

(51) International Patent Classification (IPC):
**B04B 7/00** (2006.01)        **G06F 30/17** (2020.01)
**G06F 30/28** (2020.01)

(52) Cooperative Patent Classification (CPC):
**Y02T 90/00**

(86) International application number:
**PCT/CN2024/091158**

(87) International publication number:
**WO 2024/239951 (28.11.2024 Gazette 2024/48)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **19.05.2023 CN 202310565656**

(71) Applicants:
• **CHINA NATIONAL OFFSHORE OIL (CHINA) CO.,
LTD.
Tianjin 300459 (CN)**
• **BEIJING RESEARCH CENTER OF CNOOC
(CHINA) CO., LTD.
Beijing 100028 (CN)**

(72) Inventors:
• **ZHANG, Jian**
**Tianjin 300459 (CN)**
• **SU, Yanchun**
**Tianjin 300459 (CN)**
• **WANG, Xiujun**
**Tianjin 300459 (CN)**
• **HUA, Zhao**
**Tianjin 300459 (CN)**
• **HUANG, Bo**
**Tianjin 300459 (CN)**
• **JI, Yipeng**
**Tianjin 300459 (CN)**
• **CHEN, Jiaqing**
**Tianjin 300459 (CN)**

(74) Representative: **Lorenz Seidler Gossel Part. mbB
Widenmayerstr. 23
80538 München (DE)**

(54) **DESIGN METHOD FOR LOW-SHEAR DYNAMIC SWIRLING ELEMENT**

(57)    Provided is a design method for a low-shear dynamic swirling element (100). The low-shear dynamic swirling element (100) comprises a rotating hub (102) and a plurality of blades (101) uniformly distributed in the circumferential direction of the rotating hub (102); each blade (101) comprises an inlet section (106), a middle section (107), and an outlet section (108) that are sequentially connected; the middle section (107) is separately tangent to the inlet section (106) and the outlet section (108). The low-shear dynamic swirling element (100) can realize low-shear and low-disturbance dynamic swirling, and avoid dispersed-phase droplet crushing caused by a rapid change of the tangential speed of a fluid. Moreover, the strength of the swirling flow can be effectively controlled according to the characteristics of a material to be separated, and the applicability and the stable operation interval of a centrifugal or dynamic swirling separation device are effectively improved.

FIG. 1

## Description

### Technical Field

The present invention relates to a design method for a low-shear dynamic swirling element, which falls within the technical field of oil-water cyclone separation.

### Background Art

Removal of light components with low density is an important part of wastewater treatment process. Cyclonic separation process has the advantages of simple operation, light phase, being recyclable and so on, which is widely used in petroleum, petrifaction, papermaking, food, electricity and other industrial wastewater treatment, especially oil-containing wastewater treatment in the field of petroleum and petrifaction. The cyclonic separation equipment can be divided into a static hydrocyclone and a dynamic cyclone separator according to the different swirling modes. In the static hydrocyclone, the energy requrired for the fluid to form a swirling flow is derived from the pressure differential of the fluid. Thus, a booster pump is required in the process, and the static hydrocyclone has a small single-tube capacity and a narrow optimal operating range. More importantly, the impact of high-pressure fluid on the wall or blade and the shear action inside the fluid will cause shear fracture of the light dispersed phase and increase the difficulty of subsequent phase separation during the rapid formation of swirling flow by the high-pressure fluid via the tangential inlet or axial guide blade.

The dynamic cyclone separator is directly driven by a motor, and it does not need to be pressurized by a booster pump before converting potential energy into kinetic energy. Thus, it has higher energy efficiency and better robustness, and can adapt to the change of working conditions by controlling the strength of the swirling flow. Currently, there are two types of swirling elements in dynamic cyclone separators: rotating drums and rotating blade lattices. The prototype of the dynamic cyclone separator using the rotating drum as the swirling element includes the dynamic cyclone separator jointly developed by TOTAL CFP (France) and NEYRTEC, and the tubular structure underground centrifugal separator (CDOWS) developed by Oak Ridge National Laboratory(USA), etc,. The common feature is that the drum with a large axial size not only drives the fluid to generate the swirling flow, but also serves as the separation chamber. Therefore, the strength of the swirling flow does not change during the separation. However, the structure of dynamic cyclone separator with drum-type swirling element is more complex, and it is difficult to maintain in engineering application. The maximum throughput of single equipment is limited by the size of drum. For the dynamic cyclone separator in which the rotating blade lattice drives the fluid to produce a rotation, the separation process is completed in a stationary machine barrel. Compared to the swirling element of the drum structure, its size is more compact and the structure of the separator is also simpler. All of the axial vortex separator developed by Enviro Voraxial Technology (EVTN) (USA), the compound hydrocyclone developed by Northeast Petroleum University and the intelligent compact cyclone separator developed by Baker Hughes adopt a rotating blade lattice as a swirling element. The blade lattice of the axial vortex separator is a hollow gradual spiral, the separator has a large capacity of single tube, and the maximum capacity is more than 1000 m$^3$/h. In 2019, Schlumberger (USA) acquired the axial vortex separation technology of EVTN, renamed it as "Voraxial Impeller-Induced Cyclonics", and applied it to the technical field of pre-water separation in the oil field. However, in the dynamic swirling process, the tangential velocity of the fluid increases rapidly, and the large velocity change rate of the fluid causes the strong shearing action, which will emulsify the droplets of the light dispersed phase entering the separator, and then cause the separation efficiency of the dynamic cyclone separator to decrease.

The analysis shows that although the dynamic cyclone separator with good robustness and large single-tube throughput has been widely concerned and has a good prospect, the problem of strong shear emulsification caused by the rapid increase of the tangential velocity has not been solved.

### Summary of the Invention

In view of the shear emulsification problem caused by the rapid increase of the tangential velocity of the fluid in the swirling process of the dynamic cyclone separator as described above, the present invention provides a design method for a low-shear dynamic swirling element. The swirling element designed by the method can achieve low-shear and low-disturbance dynamic swirling, and avoid dispersed-phase droplet crushing caused by a rapid change of the tangential speed of a fluid. Moreover, the strength of the swirling flow can be effectively controlled according to the characteristics of a material to be separated, and the applicability and the stable operation interval of a centrifugal or dynamic swirling separation device are effectively improved. In order to achieve the above-mentioned object, the present invention adopts the technical solutions below.

A design method for a low-shear dynamic swirling element is provided. The low-shear dynamic swirling element includes a rotating hub and a plurality of blades uniformly distributed in the circumferential direction of the rotating hub; the blades includes an inlet section, a middle section and an outlet section which are sequentially connected; the projection lines of the inlet section, the middle section and the outlet section on the rotating hub are alignment lines. The design method includes the steps of:

performing a smooth continuous design on the alignment line by a third-order Bezier curve, wherein the equation of the alignment line after smoothing is

$$P(m) = A(1-m)^3 \quad + 3mB(1-m)^2 \quad + 3m^2C(1-m) \quad + Dm^3, \quad m \in [0,1]$$

where A is (0, 0), B ($h_1\sin\varphi_{in}$, $h_1\cos\varphi_{in}$), C *(t, L-$h_2$)* and D (t, L), and A, B, C, D are the coordinates of four control points of the third-order Bezier curve; m is a parameter variable of the Bezier curve, $h_1$ and $h_2$ are lengths of the inlet and outlet sections of the blade, respectively; L is a length of the axial plane of the blade; t is a grid distance between two blades; and $\varphi_{in}$ is an inlet setting angle.

In the design method for the low-shear dynamic swirling element, preferably, the line shapes of the inlet section, the middle section and the outlet section are mutually tangential arc-shaped curves or conic curves in any one of the shunt surfaces, the centers of curvature of the curves being located on the same side.

In the design method for the low-shear dynamic swirling element, preferably, the angle between the curve of the inlet section and a rotating hub axial surface is the inlet setting angle $\varphi_{in}$ the angle between the direction of linear velocity of the fluid relative to the inlet section and the rotating hub axial surface in operation is an incoming incidence angle $\gamma$; and the swirling shear is reduced by coordinating the inlet setting angle $\varphi_{in}$ with the incoming incidence angle $\gamma$.

In the design method for the low-shear dynamic swirling element, preferably, the calculation formula of the linear velocity of the inlet section is as follows:

$$\overrightarrow{V'}_{in} = \overrightarrow{V'}_{in-\theta} + \overrightarrow{V'}_{in-z}$$

where $\overrightarrow{V'}_{in}$ is a linear velocity of the inlet section; $\overrightarrow{V'_{in-z}}$ is an axial component; and $\overrightarrow{V'_{in-\theta}}$ is a relative tangential velocity of the fluid with respect to the blade.

In the design method for the low-shear dynamic swirling element, preferably, when the incoming axial velocity is kept constant, the relative axial velocity of the fluid with respect to the blade at the inlet cross section of the blade is

$$\overrightarrow{V'_{in-z}} = \overrightarrow{V}_z = \frac{Q_{in}}{A_{in}}$$

where $\overrightarrow{V}_z$ is a fluid axial surface velocity; $A_{in}$ is a flow area at the inlet of the blade lattice; and $Q_{in}$ is the inlet flow rate.

In the design method for the low-shear dynamic swirling element, preferably, the relative tangential velocity of the fluid with respect to the blade on either cylindrical flow plane at the inlet of the blade, with the blade as a reference frame, assuming that the fluid particle flows on a cylindrical surface centered on the axis of rotation, is

$$\overrightarrow{V'_{in-\theta}} = -\overrightarrow{\omega}R_i$$

where $R_i$ is a radius of the cylindrical flow surface; and $\omega$ is an angular velocity.

In the design method of the low-shear dynamic spinner element, preferably, the inlet setting angle $\varphi_{in}$ is equal to the incoming incidence angle $\gamma$.

In the design method for the low-shear dynamic swirling element, preferably, the included angle between the curve of the outlet section and the rotating hub axial surface is an outlet setting angle $\varphi_{out}$, the rotational speed of the swirling flow being adjusted by adjusting the outlet setting *qJ out* angle $\varphi_{out}$.

In the design method for the low-shear dynamic swirling element, preferably, with the blade as a reference frame, the velocity of the fluid with respect to the blade in the outlet cross-section is

$$\overrightarrow{V'_{\text{out}}} = \overrightarrow{V'_{\text{out}-\theta}} + \overrightarrow{V'_{\text{out}-z}}$$

$$\overrightarrow{V'_{\text{out}-z}} = \frac{\overrightarrow{V_z}}{\cos\varphi_{\text{out}}}$$

where $\overrightarrow{V'_{out\text{-}\theta}}$ is a tangential velocity of the fluid relative to the blade lattice at the outlet cross-section; $\overrightarrow{V'_{out\text{-}z}}$ is a relative velocity at the outlet of the blade lattice; and $\overrightarrow{V'_{out}}$ is a velocity of the fluid relative to the blade.

In the design method for the low-shear dynamic swirling element, preferably, the outlet setting angle $\varphi_{out}$ is in the range of no less than -10 degrees and no greater than 10 degrees.

Due to the adoption of the above technical solution, the present invention has the following advantages.

1. In the present invention, the shear-free inflow of the fluid into the dynamic swirling element is achieved by coordinating the inlet setting angle $\varphi_{in}$ and the incoming incidence angle $\gamma$ so as to reduce the swirling shear and ensuring the normal velocity of the fluid in the inlet section relative to the dynamic swirling element to be zero when the inlet setting angle and the incoming incidence angle of the low-shear dynamic swirling element are the same. After the fluid enters the low-shear dynamic swirling element, the tangential velocity of the fluid increases gradually and the turbulence of the swirling process is low under the action of the gradual change curve in the middle section. Ultimately, by controlling the angle of the outlet setting angle, it is achieved that the fluid exiting the swirling element produces the desired strength of the swirling flow or centrifugal force field. Finally, the low-shear dynamic swirling process is achieved.

2. The design method for the low-shear dynamic swirling element in the present invention adopts a three-stage design concept, namely, an inlet section, a middle section and an outlet section. Here, the inlet section has the inlet setting angle, the outlet section has the outlet setting angle, and the middle section connects the inlet section and the outlet section smoothly and tangentially with the conic curve. The alignment line composed of the three sections of the curve is continuously smoothed by the third-order Bezier curve. Low-shear dynamic swirling elements with reasonable geometry and continuous smooth profile flow lines are generated with as few design parameters as possible.

## Brief Description of the Drawings

Fig. 1 is a perspective view of a low-shear dynamic swirling element according to an embodiment of the present invention;
Fig. 2 is a schematic view of the alignment line of the swirling element according to the embodiment of the present invention;
Fig. 3 is a schematic view showing the coordinates of a control point of a third-order Bezier curve according to the embodiment of the present invention; and
Fig. 4 is an expanded view of a blade in a partial flow section of the swirling element according to the embodiment of the present invention, wherein a is an expanded section of the blade in a first position after the swirling element is expanded, and b is an expanded section of the blade in a second position after the swirling element is expanded;

In the figure, the reference numerals are as follows:
100-low-shear dynamic swirling element; 101-blade; 102-rotating hub; 103-direction of rotation; 104-rotating hub axial surface; 105-incoming direction; 106-inlet section; 107-middle section; 108-outlet section; 109-alignment line; $\varphi_{in}$-inlet setting angle; $\varphi_{out}$-outlet setting angle; $\gamma$-incoming incidence angle.

## Detailed Description of the Invention

In order that the objects, aspects and advantages of the present invention will become more apparent, a more complete description of the embodiments of the present invention will be rendered by reference to specific embodiments thereof, rather than to specific embodiments thereof, which are described hereinafter. Based on the embodiments of the present invention, all other embodiments obtained by those of ordinary skill in the art without creative efforts shall fall within the protection scope of the present invention.

Unless defined otherwise, technical or scientific terms used herein shall have the ordinary meaning as understood by one of ordinary skill in the art to which this invention belongs. As used herein, the terms "first", "second", "third", "fourth", and the like do not denote any order, quantity, or importance, but rather are used to distinguish one element from another. The word "comprising" or "comprises", and the like, is intended to cover the presence of elements or items preceding the word, including the elements or items listed after the word, and equivalents thereof, without excluding other elements or items. The terms "connected" or "coupled" and the like are not limited to physical or mechanical connections, but may include electrical connections, whether direct or indirect connections.

The present invention proposes a design method for a low-shear dynamic swirling element, which adopts a three-stage design concept, namely, an inlet section, a middle section and an outlet section, for solving the shear emulsification problem caused by the rapid increase of the tangential velocity of the fluid in the swirling process of the existing dynamic cyclone separator. Here, the inlet section has the inlet setting angle, the outlet section has the outlet setting angle, and the middle section connects the inlet section and the outlet section smoothly and tangentially with the conic curve. The alignment line composed of the three sections of the curve is continuously smoothed by the third-order Bezier curve. Low-shear dynamic swirling elements with reasonable geometry and continuous smooth profile flow lines are generated with as few design parameters as possible.

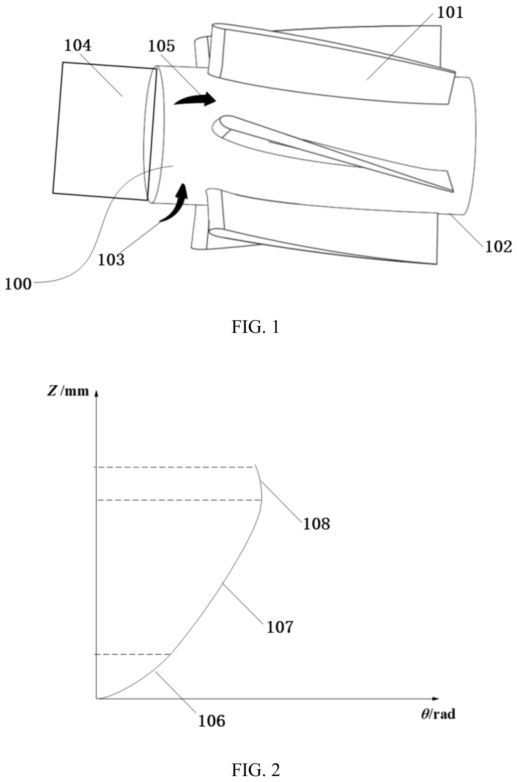

As shown in Fig. 1, a low-shear dynamic swirling element 100 according to the present invention includes a rotating hub 102 and a plurality of blades 101 uniformly distributed in the circumferential direction of the rotating hub 102; the blade 101 includes an inlet section 106, a middle section 107, and an outlet section 108 which are sequentially connected; and the middle section 107 is separately tangent to the inlet section 106 and the outlet section 108.

The calculation formula for the linear velocity of the inlet section 106 is as follows:

$$\overrightarrow{V'}_{\text{in}} = \overrightarrow{V'}_{\text{in}-\theta} + \overrightarrow{V'}_{\text{in}-z}$$

where $\overrightarrow{V'}_{\text{in}}$ is a linear velocity of the inlet section; is an axial component; and $\overrightarrow{V'}_{\text{in-}\theta}$ is a relative tangential velocity of the fluid with respect to the blade 101.

When the incoming axial velocity is kept constant, the relative axial velocity of the fluid with respect to the blade 101 at the inlet cross section of the blade 101 is

$$\overrightarrow{V'}_{\text{in}-z} = \overrightarrow{V}_z = \frac{Q_{\text{in}}}{A_{\text{in}}}$$

where $\overrightarrow{V}_z$ is a fluid axial surface velocity; $A_{\text{in}}$ is a flow area at the inlet of the blade lattice; and $Q_{\text{in}}$ is the inlet flow rate.

The relative tangential velocity of the fluid with respect to the blade 101 on either cylindrical flow plane at the inlet of the blade 101, with the blade 101 as a reference frame, assuming that the fluid particle flows on a cylindrical surface centered on the axis of rotation, is

$$\overrightarrow{V'}_{\text{in}-\theta} = -\overrightarrow{\omega} R_{\text{i}}$$

where $R_{\text{i}}$ is a radius of the cylindrical flow surface; and $\omega$ is an angular velocity.

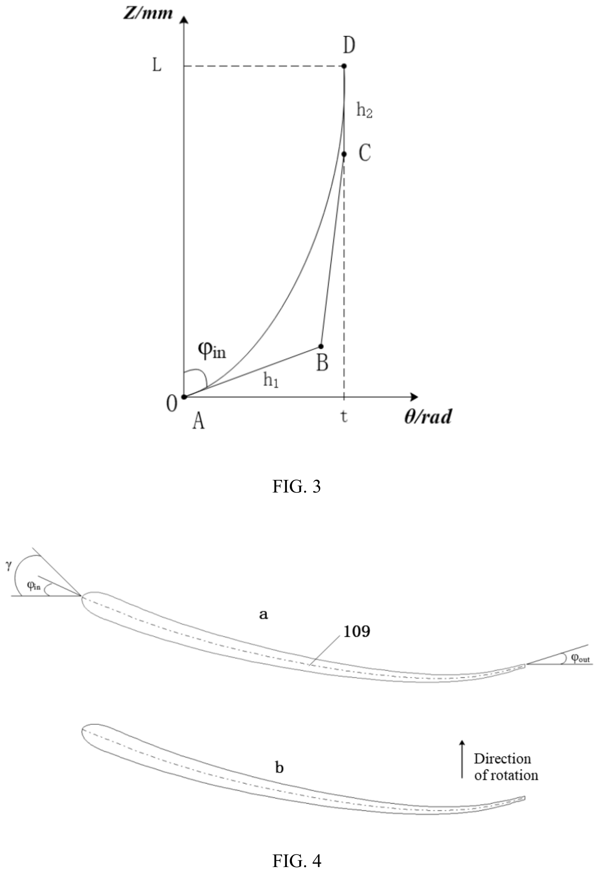

As shown in Fig. 4, the incoming incidence angle y is the angle between the incoming axial plane velocity and the linear velocity of the fluid relative to the inlet section 106 of the blade 101 when the low-shear dynamic swirling element 100 is in operation.

The inlet setting angle $\varphi_{\text{in}}$ is an included angle formed between the curve of the inlet section 106 of the blade 101 and the rotating hub axial surface 104. The inlet setting angle $\varphi_{\text{in}}$ is determined according to the relationship with the incoming incidence angle $\gamma$. The inlet setting angle $\varphi_{\text{in}}$ is connected to the inlet section 106 of the blade 101.

The swirling shear is reduced by coordinating the inlet setting angle $\varphi_{\text{in}}$ with the incoming incidence angle $\gamma$. When the inlet setting angle $\varphi_{\text{in}}$ is not equal to $\gamma$, the fluid will directly impact the side wall of the blade 101 in the relative motion with the blade 101 as the reference frame. Thus, the fluid will be subjected to strong shear at the inlet. When y = $\varphi_{in,}$ the vector direction of the relative velocity $\overrightarrow{V'}_{\text{in}}$ is parallel to the blade 101, and the shear effect caused by the change in tangential velocity in the axial direction can also be eliminated, thereby achieving low-shear dynamic swirling. According to the velocity vector relationship, the inlet setting angle $\varphi_{\text{in}}$ can be obtained, namely, the setting angle

$$\gamma = \varphi_{\text{in}} = arctan \frac{\overrightarrow{V}_z}{\overrightarrow{V'}_{\text{in}-\theta}}$$

. $\overrightarrow{V}_z$ is the axial surface velocity of the fluid, and $\overrightarrow{V'}_{\text{in-}\theta}$ is the relative tangential velocity of the fluid with respect to the blade 101. Thus, the tangential velocity of the fluid with respect to the blade 101 must be "0", so that strong shearing due to a large tangential velocity difference between the blade 101 and the fluid is avoided. Of course, the inlet setting angle $\varphi_{in}$ is not limited to being equal to the incoming incidence angle $\gamma$, and it is within the scope of the present invention to use an approach in which the inlet setting angle $\varphi_{in}$ is coordinated with the incoming incidence angle $\gamma$ to reduce the swirling shear.

The outlet setting angle $\varphi_{out}$ is the angle formed by the curve of the outlet section 108 of the blade 101 and the rotating hub axial surface 104. The outlet setting angle $\varphi_{out}$ is determined based on the rotational speed of the low-shear dynamic swirling element 100 and the required *Pout* strenth of the swirling flow of the material to be separated. The outlet setting angle is connected to the outlet section 108 of the blade 101. The rotational speed of the swirling flow is $\varphi_{out}$ adjusted by adjusting the outlet setting angle .

With the blade 101 as the reference frame, the velocity of the fluid relative to the blade 101 at the outlet cross-section is

$$\overrightarrow{V'}_{out} = \overrightarrow{V'}_{out-\theta} + \overrightarrow{V'}_{out-z}$$

$$\overrightarrow{V'}_{out-z} = \frac{\overrightarrow{V_z}}{\cos \varphi_{out}}$$

where $\overrightarrow{V'_{out-0}}$ is a tangential velocity of the fluid relative to the blade lattice at the outlet cross-section; $V'_{out-z}$ is a relative velocity at the outlet of the blade lattice; and $\overrightarrow{V_{out}}$ is a velocity of the fluid relative to the blade 101.

Ignoring the thickness of the blades 101, assuming that the number of the blades 101 is infinite, when the outlet setting angle of the blades 101 is 0°, the tangential velocity of the fluid flowing out of the blades 101 is the same as that of the blades 101, and then

$$\overrightarrow{V'}_{out-\theta} = 0$$

In some specific embodiments of the present invention, the outlet setting angle $\varphi_{out}$ is set at 0°, and may be increased or decreased as appropriate according to the required strength of the swirling flow. When the outlet setting angle $\varphi_{out}$ is greater than 0°, the rotation speed of the fluid flowing out of the blade is lower than the rotation speed of the blade, but it is beneficial to reduce the pressure loss in the separation process, generally not greater than 10 °. When the outlet setting angle is less than 0 degree, the rotational speed of the fluid flowing out of the blade is higher than the rotational speed of the blade, but a pressure loss is caused, generally not less than -10 degrees. Of course, the outlet setting angle $\varphi_{out}$ is not limited to $\pm$10 degrees. The method of adjusting the rotational speed of the swirling flow by changing the outlet setting angle $\varphi_{out}$ falls within the scope of the present invention.

As shown in Figs. 2 and 3, the line shapes of the inlet section 106, the middle section 107 and the outlet section 108 are mutually tangential arc-shaped curves or conic curves in any one of the shunt surfaces, the centers of curvature of the curves being located on the same side. In some embodiments, the middle section 107 is a smooth continuous conic curve. After the fluid enters the middle section 107 of the blade 101, the tangential velocity of the fluid gradually increases in a conic manner with the change of the curvature of the blade in the middle section 107, and the gradual increase of the tangential velocity of the fluid greatly reduces the disturbance caused by the rotation of the fluid pushed by the blade 101.

The projection lines of the inlet section 106, the middle section 107 and the outlet section 108 on the rotating hub 102 are alignment lines 109, and a smooth continuous design is performed by a third-order Bezier curve alignment line 109. The equation of the alignment lines 109 after smoothing is

$$P(m) = A(1 - m)^3 + 3mB(1 - m)^2 + 3m^2C(1 - m) + Dm^3, \quad m \in [0,1]$$

where A is $(0, 0)$, B $(h_1\sin\varphi_{in}, h_1\cos\varphi_{in})$, C $(t, L\text{-}h_2)$ and D $(t, L)$, and A, B, C, D are the coordinates of four control points of the third-order Bezier curve; m is a parameter variable of the Bezier curve, $h_1$ and $h_2$ are lengths of the inlet and outlet sections of the blade, respectively; L is a length of the axial plane of the blade; t is a grid distance between two blades; and $\varphi_{in}$ is an inlet setting angle. The curvature of the middle section 107 may be accomplished by adjusting the lengths of $h_1$ and $h_2$. It is thus possible to quickly design the alignment line 109 after successive fairings with as few parameters as possible.

In operation of the low-shear dynamic swirling element 100 of the present invention, the fluid flowing into the low-shear dynamic swirling element 100 and the blades 101 rotate together in the direction of rotation 103 at a rotational speed. The equal inlet setting angle $\varphi_{in}$ and incoming incidence angle $\gamma$ at the inlet section 106 enable the normal velocity of the fluid at the inlet section 106 relative to the low-shear dynamic swirling element 100 to be zero, ensuring that the fluid enters the low-shear dynamic swirling element 100 without shear.

The curvature of the middle section 107 is consistent with the rate of change of the fluid velocity, which not only controls the rotational velocity of the fluid entering the blade region, but also minimizes the impact of the dispersed phase particles in the process of vortex formation. It avoids the disturbance of the fluid caused by the dynamic swirling process.

After the fluid exits the low-shear dynamic swirling element 100 from the outlet section 108 along the outlet set angle $\varphi_{out}$, a rotating flow field or centrifugal force field is formed, thus completing the low-shear dynamic swirling process.

The low-shear dynamic swirling element 100 of the present invention includes three sections, an inlet section 106, a middle section 107, and an outlet section 108. Here, the inlet setting angle at the inlet section 106 is equal to the incoming incidence angle $\gamma$, so that the normal velocity of the fluid at the inlet section 106 relative to the low-shear dynamic swirling element 100 is zero, ensuring that the fluid enters the flow channel region between the swirling blades 101 smoothly without shear. The middle section 107 is a conic curve, and the rotation speed of the fluid entering the blade region is controlled by slowly changing the included angle between the blade tangent and the rotating hub axial surface 104, thereby forming the required centrifugal strength. The outlet setting angle $\varphi_{out}$ at the outlet section 108 is determined according to the rotational speed of the low-shear dynamic swirling element 100 and the required strength of the swirling flow. When the rotational speed of the element is fixed, different strengths of the swirling flows can be obtained by adjusting the angle. The third-order Bezier curve is used to smooth the alignment line 109 of the whole swirling element, and the curvature of the middle section 107 is more consistent with the rate of change of the fluid velocity, which reduces the impact of the dispersed phase particles during the formation of the swirling flow. The low-shear dynamic swirling element 100 realizes the low-shear and low-disturbance swirling of the centrifugal separation equipment, prevents the shear breakup of the dispersed phase droplets in the dynamic swirling process, and greatly enhances the separation performance of the centrifugal or cyclone separation equipment. It can also effectively control the strength of the swirling flow according to the characteristics of the materials to be separated, improving the applicability of the centrifugal or cyclone separation equipment.

Finally, it should be noted that the above embodiments are only intended to illustrate the technical solutions of the present invention, not to limit them. Although the present invention has been described in detail with reference to the foregoing embodiments, those skilled in the art will understand that they may still modify the technical solutions described in the foregoing embodiments or equivalently replace some of the technical features. Such modifications or replacements will not cause the essence of the corresponding technical solutions to depart from the spirit and scope of the technical solutions of the embodiments of the present invention.

## Claims

1.  A design method for a low-shear dynamic swirling element, the low-shear dynamic swirling element (100) comprising a rotating hub (102) and a plurality of blades (101) uniformly distributed in the circumferential direction of the rotating hub (102); the blades (101) comprising an inlet section (106), a middle section (107) and an outlet section (108) which are sequentially connected; projection lines of the inlet section (106), the middle section (107) and the outlet section (108) on the rotating hub (102) being alignment lines (109), **characterized in that** the design method comprises the steps of:

    performing a smooth continuous design on the alignment line (109) by a third-order Bezier curve, wherein the equation of the alignment line (109) after smoothing is

    $$P(m) = A(1-m)^3 \quad + 3mB(1-m)^2 \quad + 3m^2C(1-m) \quad + Dm^3, \quad m \in [0,1]$$

    where A is (0, 0), B ($h_1\sin\varphi_{in}$, $h_1\cos\varphi_{in}$), C (t, L-$h_2$) and D (t, L), and A, B, C, D are the coordinates of four control points of the third-order Bezier curve; m is a parameter variable of the Bezier curve, $h_1$ and $h_2$ are lengths of the inlet and outlet sections of the blade, respectively; L is a length of the axial plane of the blade; t is a grid distance between two blades; and $\varphi_{in}$ is an inlet setting angle.

2.  The design method for the low-shear dynamic swirling element according to claim 1, **characterized in that** line shapes of the inlet section (106), the middle section (107) and the outlet section (108) are mutually tangential arc-shaped curves or conic curves in any one of the shunt surfaces, the centers of curvature of the curves being located on the same side.

3.  The design method for the low-shear dynamic swirling element according to claim 1, **characterized in that** the angle between a curve of the inlet section (106) and a rotating hub axial surface (104) is the inlet setting angle $\varphi_{in}$, an angle between a direction of a linear velocity of a fluid relative to the inlet section (106) and the rotating hub axial surface (104) in operation is an incoming incidence angle $\gamma$; and swirling shear is reduced by coordinating the inlet setting angle $\varphi_{in}$ with the incoming incidence angle $\gamma$.

4. The design method for the low-shear dynamic swirling element according to claim 3, **characterized in that** the calculation formula of the linear velocity of the inlet section (106) is as follows:

$$\overrightarrow{V'}_{\text{in}} = \overrightarrow{V'}_{\text{in}-\theta} + \overrightarrow{V'}_{\text{in}-z}$$

where $\overrightarrow{V'_{\text{in}}}$ is a linear velocity of the inlet section; is an axial component; and $V'_{\text{in}-\theta}$ is a relative tangential velocity of the fluid with respect to the blade 101.

5. The design method for the low-shear dynamic swirling element according to claim 4, **characterized in that**, when the incoming axial velocity is kept constant, a relative axial velocity of the fluid with respect to the blade (101) at an inlet cross section of the blade (101) is

$$\overrightarrow{V'}_{\text{in}-z} = \overrightarrow{V}_{\text{z}} = \frac{\overrightarrow{Q}_{\text{in}}}{A_{\text{in}}}$$

where $\overline{V_{\text{z}}}$ is a fluid axial surface velocity; $A_{\text{in}}$ is a flow area at an inlet of a blade lattice; and $Q_{\text{in}}$ is an inlet flow rate.

6. The design method for the low-shear dynamic swirling element according to claim 4, **characterized in that** the relative tangential velocity of the fluid with respect to the blade (101) on either cylindrical flow plane at the inlet of the blade (101), with the blade (101) as a reference frame, assuming that a fluid particle flows on a cylindrical surface centered on an axis of rotation, is

$$\overrightarrow{V'}_{\text{in}-\theta} = -\overrightarrow{\omega} R_{\text{i}}$$

where $R_{\text{i}}$ is a radius of the cylindrical flow surface; and $\omega$ is an angular velocity.

7. The design method for the low-shear dynamic swirling element according to claim 3, **characterized in that** the inlet setting angle $\varphi_{\text{in}}$ is equal to the incoming incidence angle $\gamma$.

8. The design method for the low-shear dynamic swirling element according to claim 1, **characterized in that** an included angle between a curve of the outlet section (108) and the rotating hub axial surface (104) is an outlet setting angle $\varphi_{out}$, and a rotational speed of a swirling flow is adjusted by adjusting the outlet setting angle $\varphi_{out}$.

9. The design method for the low-shear dynamic swirling element according to claim 8, **characterized in that**, with the blade (101) as a reference frame, a velocity of a fluid with respect to the blade (101) in an outlet cross-section is

$$\overrightarrow{V'}_{\text{out}} = \overrightarrow{V'}_{\text{out}-\theta} + \overrightarrow{V'}_{\text{out}-z}$$

$$\overrightarrow{V'}_{\text{out}-z} = \frac{\overrightarrow{V}_{\text{z}}}{\cos\varphi_{\text{out}}}$$

where $\overrightarrow{V}_{\overline{out}-0}$ is a tangential velocity of the fluid relative to a blade lattice at the outlet cross-section; $\overrightarrow{V}_{\overline{out}-z}$ is a relative velocity at an outlet of the blade lattice; and $\overrightarrow{V_{out}}$ is a velocity of the fluid relative to the blade (101).

10. The design method for the low-shear dynamic swirling element according to claim 8 **characterized in that** the outlet setting angle $\varphi_{out}$ is in the range of no less than -10 degrees and no greater than 10 degrees.

FIG. 1

FIG. 2

FIG. 3

FIG. 4

## INTERNATIONAL SEARCH REPORT

| | International application No. |
|---|---|
| | **PCT/CN2024/091158** |

**A. CLASSIFICATION OF SUBJECT MATTER**

B04B7/00(2006.01)i; G06F30/17(2020.01)i; G06F30/28(2020.01)i

According to International Patent Classification (IPC) or to both national classification and IPC

**B. FIELDS SEARCHED**

Minimum documentation searched (classification system followed by classification symbols)

IPC:B04B G06F B04C

Documentation searched other than minimum documentation to the extent that such documents are included in the fields searched

Electronic data base consulted during the international search (name of data base and, where practicable, search terms used)

CNTXT, ENTXT, ENTXTC, VEN, DWPI, CJFD, CNKI: 动态, 分离, 低剪切, 光滑, 减少, 降低, 剪切, 3段, 三段, 安放角, 进口, 来流, 入流, 贝塞尔, 曲线, 三次, 三阶, 旋流, 旋流器, 旋转叶栅, 旋转栅, 叶片, 设计, 四次, 四点, 四点三次, 准线, 曲线, bezier, Bezier, lamina?, Bézier, vane?, dynamic, reduc+, decreas+, cut+, design+, angle, curve.

**C. DOCUMENTS CONSIDERED TO BE RELEVANT**

| Category* | Citation of document, with indication, where appropriate, of the relevant passages | Relevant to claim No. |
|---|---|---|
| PX | CN 116273509 A (CHINA NATIONAL OFFSHORE OIL CORP. et al.) 23 June 2023 (2023-06-23) claims 1-10 | 1-10 |
| A | CN 200963611 Y (BEIJING DELEI TECHNOLOGY DEVELOPMENT CO., LTD.) 24 October 2007 (2007-10-24) description, specific embodiments, and figures 1-7 | 1-10 |
| A | CN 102762308 A (VIENNA UNIVERSITY OF TECHNOLOGY) 31 October 2012 (2012-10-31) entire document | 1-10 |
| A | CN 105880045 A (SHIHEZI UNIVERSITY) 24 August 2016 (2016-08-24) entire document | 1-10 |
| A | US 2002030011 A1 (MARITIME SOLUTIONS INC.) 14 March 2002 (2002-03-14) entire document | 1-10 |

☑ Further documents are listed in the continuation of Box C.   ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **08 July 2024** | **30 July 2024** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT

International application No.

**PCT/CN2024/091158**

### C.    DOCUMENTS CONSIDERED TO BE RELEVANT

| Category* | Citation of document, with indication, where appropriate, of the relevant passages | Relevant to claim No. |
|---|---|---|
| A | 王子瑞等 (WANG, Zirui et al.). "基于响应面法的贯流式水轮机转轮叶片优化设计 (Tubular Turbine Runner Blade Optimization Design Based on the Response Surface Method)"<br>大电机技术 *(Large Electric Machine and Hydraulic Turbine),*<br>30 November 2015 (2015-11-30), pages 43-46<br>    section 1 | 1-10 |

Form PCT/ISA/210 (second sheet) (July 2022)

**INTERNATIONAL SEARCH REPORT**
Information on patent family members

International application No.

**PCT/CN2024/091158**

| Patent document cited in search report | | | Publication date (day/month/year) | Patent family member(s) | | | Publication date (day/month/year) |
|---|---|---|---|---|---|---|---|
| CN | 116273509 | A | 23 June 2023 | CN | 116273509 | B | 25 August 2023 |
| CN | 200963611 | Y | 24 October 2007 | | None | | |
| CN | 102762308 | A | 31 October 2012 | EP | 2525917 | A1 | 28 November 2012 |
| | | | | PE | 20130510 | A1 | 22 April 2013 |
| | | | | AT | 508900 | B1 | 15 May 2011 |
| | | | | WO | 2011088491 | A1 | 28 July 2011 |
| | | | | US | 2012292264 | A1 | 22 November 2012 |
| | | | | US | 9238234 | B2 | 19 January 2016 |
| | | | | CL | 2012002002 | A1 | 08 November 2013 |
| | | | | AT | 508900 | A4 | 15 May 2011 |
| | | | | CN | 102762308 | B | 25 May 2016 |
| | | | | IN | 201206367 | P1 | 03 January 2014 |
| CN | 105880045 | A | 24 August 2016 | CN | 204866241 | U | 16 December 2015 |
| | | | | CN | 105880045 | B | 12 October 2018 |
| US | 2002030011 | A1 | 14 March 2002 | US | 6500345 | B2 | 31 December 2002 |

Form PCT/ISA/210 (patent family annex) (July 2022)